(19) Europäisches Patentamt

European Patent Office

Office européen des brevets

(11) EP 1 172 928 A2

(12) EUROPEAN PATENT APPLICATION

(43) Date of publication:
**16.01.2002 Bulletin 2002/03**

(51) Int Cl.$^7$: **H03D 7/16**

(21) Application number: **00600011.1**

(22) Date of filing: **31.08.2000**

(84) Designated Contracting States:
**AT BE CH CY DE DK ES FI FR GB GR IE IT LI LU MC NL PT SE**
Designated Extension States:
**AL LT LV MK RO SI**

(30) Priority: **14.07.2000 GR 00100236**

(71) Applicant: **Intracom S.A. Hellenic Telecommunications & Electronics Industry 19002 Peania, Athens (GR)**

(72) Inventors:
• **Papanastasiou, Lelouda Peania, Athens (GR)**
• **Dervenis, Dimitrios Peania, Athens (GR)**
• **Tsakoumakou, Katerina Peania, Athens (GR)**

(74) Representative: **Makris, Maria K. Intracom S.A., Premetis 3, Marousi 15125 Athens (GR)**

(54) **DC offset correction circuit and AGC in zero-if wireless receivers**

(57) In Direct Conversion receivers the baseband analog modulated signal is produced directly from the high frequency signal received at the antenna. As the baseband signal is extended to zero intermediate frequency, an error signal (at DC or of very low frequency) is added. The spectrum of the modulated signal overlaps with the one of the error signal. Consequently saturation at the following stages or deterioration at the performance of the demodulator could occur.

The level of the error signal depends upon the frequency and the power of the received signal at the antenna, the frequency and the level of the LO signal, the power supply level, the temperature, as well as the environment that surrounds the receiver (high frequency signal leaks to the antenna, radiated and reflected from moving objects back to the receiver).

The baseband signal is sampled and converted to digital by ADC converters. The method proposed includes a dynamic calculation of the error signal value, using as input each digital sample, through an algorithm that is implemented in digital circuitry. The value of the calculated error function is updated in every sample and through DAC converters is subtracted at the output of the mixers. The correction of the error signal is combined with the AGC control signal which is calculated also through the digital algorithm and can also be updated in every sample.

In this way any low frequency component at the error signal could be tracked and corrected. This is very important when the low level signal is present as the amplification gain through the AGC is high. In that case any error signal added ( usually its level is much higher than the one of the received signal) could overflow the following stages.

Another point is that in the case of a significant change at both the values of the error signal and the power of the received signal the algorithm converges to the new values.

The algorithm includes also the correction of the static DC offset (at he case that no signal is present at the antenna) through a separate DAC converter.

Figure 2

**Description**

**BACKGROUND OF THE INVENTION**

This invention relates to a correction circuit which eliminates the effect of DC Offset voltages at the analog baseband modulation components, in-phase I and quadrature-phase Q. The peak value of the analog input signals is also calculated and adjusted to a desired level. The circuit is included at the baseband part of a digital zero-IF (intermediate frequency) receiver.

In wireless communication systems, the architecture of the receiver strongly affects the error components that are imposed at the produced baseband signals. The zero-IF receiver (also called homodyne) translates the band of interest directly to zero frequency. Since the downconverted band extends to zero frequency, extraneous offset voltages can corrupt the signal and more importantly saturate the following stages. In some cases the DC Offset components are larger than the smallest signal that must be detected.

The architecture of the receiver also employs low pass filtering to suppress nearby interferers (ex. channel selection filtering). These low pass filters are usually of high order. Due to the difficulty of achieving good performance for such kind of filters, these blocks can also be implemented in the digital part (after analogue-to-digital converter ADC). In that way simple anti-alias filters are used at the input of the ADC converters.

The most well understood DC Offset correction method is to employ AC coupling to the I and Q signals after the mixers. This method works very well for certain modulation types. But for today's narrow band digital cellular standards with Time Division Multiple Access (TDMA) this method suffers from two problems. In a TDMA-structure system the analog signals are modulated within assigned time slots. As the spectrum of random binary data exhibits a peak at dc, such signals may be corrupted if filtered with a high corner frequency. A low value for the corner frequency yields a slow response to variations of the offset and requires for the implementation large capacitors and resistors. These components can not be integrated. The idea of ac coupling works only when the DC offset is constant which is not valid for TDMA systems.

Another method that has been suggested is to employ differentiation at the I and Q baseband signals in order to remove the DC component. Then amplify and digitize the differentiated signal and feed the numerical I,Q values to the digital signal processor DSP. Re-integrate the differentiated digital signal in the DSP to restore the original signal. The re-integration could also be performed at the baseband analog part before the ADC converter. The differentiation is described by the Laplace transform aS simply, while the AC coupling is described by (aS)/(1+aS). The denominator term (1+aS) is a low-frequency pole that causes AC coupling to have a long memory, while this is avoided in the pure differentiator aS. That means that the method converges in a few bits time, although an arbitrary constant is introduced, which is less than the peak value of the received signal. This is caused by the non zero input signal amplitude when the re-integration starts. The presence of the arbitrary constant at the analog baseband signal does not allow the maximum suppression of the dynamic range of the input signal. This decreases the signal-to-noise ratio, SNR, performance of the ADC (6db). The remaining offset at the digital signal should be compensated, as it can affect the performance of the detector. The second problem is that this compensation method does not allow the subtraction of a possible wander at the DC offset and does not converge for any change of the DC offset during the slot (which may cause overflow at the baseband stages).

The preamble in a receiver is used for clock and carrier synchronization. During the preamble time window DC offset compensation can be performed using a short known symbol sequence. A possible wander at the DC offset or a change during the slot corrupts the results of the method.

**SUMMARY OF THE INVENTION**

In direct conversion receivers the baseband analog modulated signal is produced directly from the high frequency signal received at the antenna. As the baseband signal is extended to zero intermediate frequency, an error signal (at DC or of very low frequency) is added. The spectrum of the modulated signal overlaps with the one of the error signal. Consequently, saturation at the following stages or deterioration of the performance of the demodulator could occur.

The baseband signal is sampled and converted to digital by ADC converters. According to the invention, a dynamic calculation of the error signal value is performed, using as input each digital sample, through an algorithm that is implemented in digital circuitry. The value of the calculated error function is updated in every sample and through digital-to-analog DAC converters is subtracted at the output of the mixers. The correction of the error signal is combined with the automatic gain control AGC signal which is calculated also through the digital algorithm and can also be updated in every sample.

In this way any low frequency component of the error signal could be tracked and corrected. This is very important when the low level signal is present as the amplification gain through the AGC is high. In that case any error signal added ( usually its level is much higher than the one of the received signal ) could overflow the following stages.

In the case of a significant change in both the values of the error signal and the power of the received signal the algorithm converges to the new values.

The algorithm also includes the correction of the static DC offset (in the case that no signal is present at the antenna) through a separate DAC converter.

## BRIEF DESCRIPTION OF THE DRAWINGS

For better understanding of the invention, the following description should be read in conjunction with the accompanying drawings:

Fig. 1    shows a direct conversion receiver which includes the invented Offset Correction Algorithm, OCA and the Automatic Gain Control Algorithm, AGCA;

Fig. 2    shows the I and Q baseband signals at the output of the mixers;

Fig. 3    shows the generated analog correction signals for the DC offset;

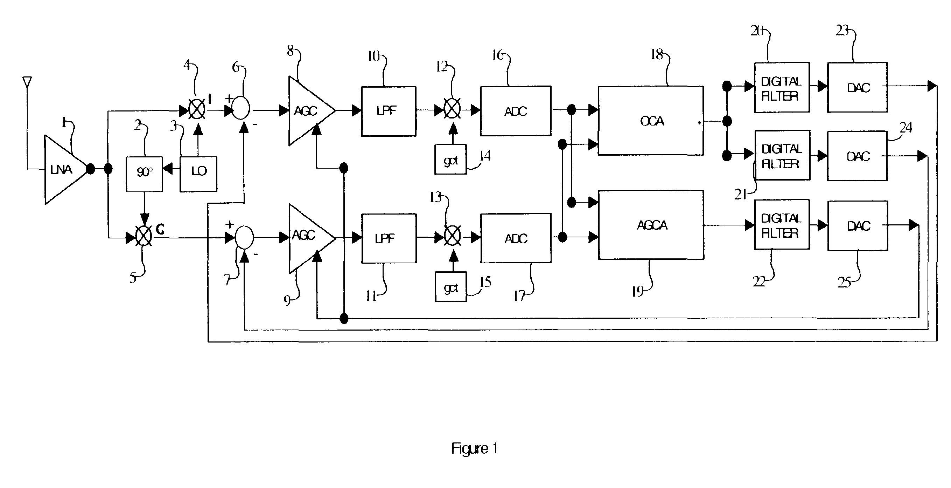

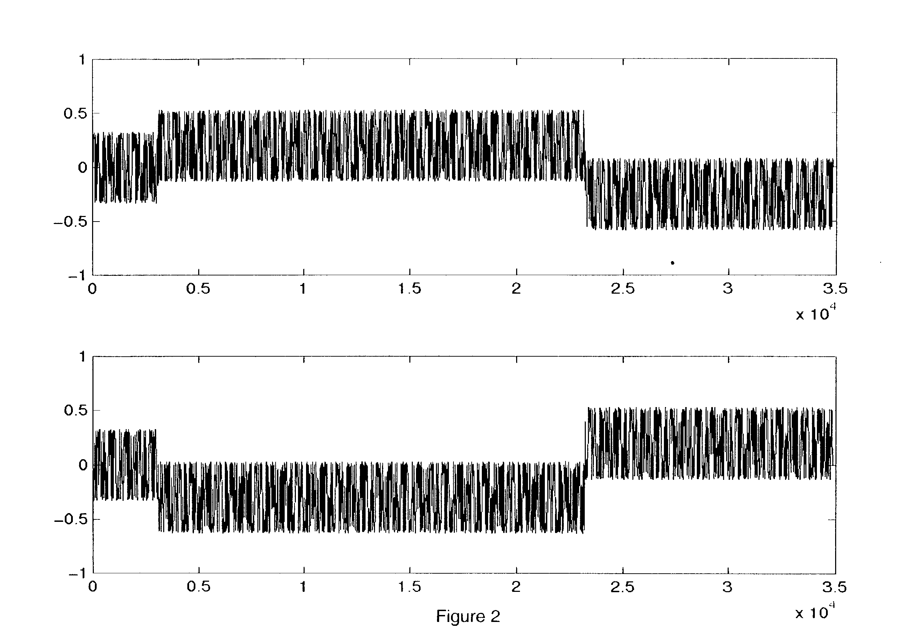

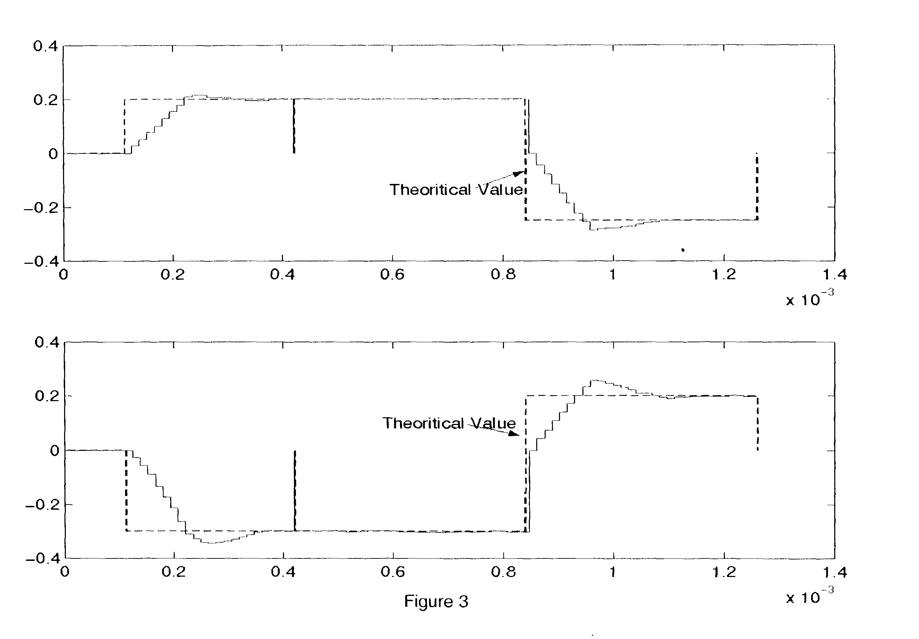

The results presented at the figures 2,3 refer to the block diagram presented at the figure 1.

The results are indicative concerning the performance of the invention.

## DETAILED DESCRIPTION OF THE INVENTION

The objective of the present invention is to provide an offset correction method, that could cope with the DC errors produced by every source in a wireless receiver. The method suggested is also combined with an Automatic Gain Control, AGC, function.

A first source of offset is due to the non-infinite isolation between the Local Oscillator, LO 3, port and the inputs of the mixers, 4 and 5, and the Low Noise Amplifier, LNA 1, port which is called local oscillator leakage. The signal provided by the local oscillator partly leaks to mixer input and the LNA input. This is caused by capacitive or inductive crosstalk. The result of the crosstalk at both cases is added at the received signal, at the mixer's input port. Consequently the mixer multiplies the received signal with the local oscillator signal. The result of this operation includes the square of the local oscillator signal multiplied by an attenuation factor (depends on the achieved isolation), which is a DC part. The resulted offset depends on the level of the local oscillator signal, and varies with the frequency of the local oscillator signal (normally increases with frequency).

A second source of offset is due also to the non-infinite isolation between the LNA input port and the LO port of the mixer and it is called self-mixing. The signal appearing at the inputs of the LNA and the mixer partly leaks to the LO input port of the mixer. The result of the multiplication operation, performed by the mixer, includes a DC part. The value of the DC part depends on the square of the received signal multiplied by an attenuation factor. The resulted DC offset depends on the frequency of the received signal (increases with frequency), as well as on its power level. The dynamic range of the DC offset in this case is wide due to the wide dynamic range of the received signal.

A third offset source is caused when the local oscillator signal leaks to the antenna and is radiated and subsequently reflected from moving objects back to the receiver. This case of self-mixing varies with time. For example when a car moves at a high speed, the reflections may change rapidly. Thereby a part of the local oscillator signal is added to the received signal, introducing an offset at the mixer's output port. The resulted DC offset depends upon the frequency and the level of the local oscillator signal. Since this offset is due to leakage via the environment it is also influenced by the position of the receiver.

A fourth source is due to the components' mismatches and depends on the power supply level and the temperature.

The DC offset introduced by the first and fourth mentioned sources could theoretically be measured and compensated at fabrication, as it depends on the frequency and the level of the local oscillator signal and the components' mismatches. However the level of the DC offset at all cases varies with temperature, time and part. Also there is an additional cost at production, as the measurements and the compensation procedure should be performed at each part.

The DC offset introduced by the second and the third offset source consists of unpredictable parts, as it is depended upon the power level and the frequency of the received signals and the position of the receiver. Another important point is the possibility of a low frequency wander to be present and of a change at the DC offset level during the slot time window due to the third DC offset source.

Another important problem is the wide dynamic range of the RF signal at the antenna. The RF signal is translated, after downconversion, to a wide dynamic range, baseband signal. The low level, input signals deteriorate the signal-to-noise ratio SNR performance of the baseband part. In order to suppress the dynamic range of the baseband signal to a desired level at the ADC's, 16 and 17, input and maximize the SNR, an AGC loop should be developed. In that way the signals at the ADCs' inputs are amplified to a desired level.

The DC offset compensation and the AGC should be done at the output of the mixers, 4 and 5, in order to suppress the wide dynamic range of the baseband signal and eliminate the possibility of overflowing the next baseband stages (Low Pass filters 10 and 11 and ADCs 16 and 17 at both paths). In figure 1 the block diagram of the zero-IF receiver including the Offset Correction Algorithm, OCA 18, and the Automatic Gain Control Algorithm, AGCA 19, is shown.

The DC offset errors of both I and Q components are calculated dynamically at the digital part and corrected at the analog part (mixers' 4 and 5 output ports). The same is valid for the peak value of both I and Q components. Using the digital-to-analog, DAC, converters 23 and 24, two analog voltages are generated and through a closed loop algorithm they correct the offset of the baseband signals. A third DAC Converter 25 generates an analog voltage that decides the gain of the AGC stage.

In case no input is present at the antenna, the voltage at the mixers' 4 and 5 outputs should be a DC value, representing the static DC Offset. This is caused by the components mismatches included at the previous analog stages. Through the ADC converters 16 and 17 the samples are digitized and filtered. The produced values are used as initial values when signal is present at the antenna. The quantization step of the DAC converters 23 and 24 is critical, as it is combined with AGC, especially at the case of high gain amplification present at the loop.

The suggested Offset Calculation Algorithm, implemented in OCA 18, is explained in the following paragraphs. At the output of the mixers the I and Q components can be expressed using the following formulas:

$$S_i(t) = (I_1(t) \times \cos(\Delta\omega_1 \bullet t) + Q_1 \times \sin(\Delta\omega_1 \bullet t)) + (I_2(t) \times \cos(\Delta\omega_2 \bullet t) + Q_2 \times \sin(\Delta\omega_2 \bullet t)) \quad (1)$$

$$\underbrace{\longrightarrow \text{Desired Channel} \longleftarrow}_{} \quad \underbrace{\longrightarrow \text{Second Channel} \longleftarrow}_{}$$

$$S_q(t) = (Q_1(t) \times \cos(\Delta\omega_1 \bullet t) - I_1 \times \sin(\Delta\omega_1 \bullet t)) + (Q_2(t) \times \cos(\Delta\omega_2 \bullet t) - I_2 \times \sin(\Delta\omega_2 \bullet t)) \quad (2)$$

$$\underbrace{\longrightarrow \text{Desired Channel} \longleftarrow}_{} \quad \underbrace{\longrightarrow \text{Second Channel} \longleftarrow}_{}$$

where,

$S_i(t)$:     the received signal for I component at the mixer's 4 output
$S_q(t)$:     the received signal for Q component at the mixer's 5 output
$I_1(t)$:     the transmitted modulation signal for I component for the desired channel
$Q_1(t)$:     the transmitted modulation signal for Q component for the desired channel
$I_2(t)$:     the transmitted modulation signal for I component for the second channel
$Q_2(t)$:     the transmitted modulation signal for Q component for the second channel
$\Delta\omega 1$ :     the mismatch between the values of the up-conversion and down-conversion LO in Tx and Rx at the desired channel
$\Delta\omega 2$:     $\Delta\omega 2 - \Delta\omega 1 = k \times \omega_{ch}$, k=1,2,... , $\omega ch$ is the channel spacing frequency

The above equations represent the baseband signals at the outputs of the mixers 4 and 5, at the case that error signals are not taken into account, for both modulation components. We assume that the channel selection is performed at the digital part. We present the Si&Sq functions (eq. (1)&(2)) using one more channel except the desired one for simplicity reasons. At the case that the error signals are taken into account at both modulation components the following equations are valid:

$$S_{ie}(t) = S_i(t) + err_i(t) \quad (3)$$

$$S_{qe}(t) = S_q(t) + err_q(t) \quad (4)$$

where,

err$_i$(t) : error signal from downconversion, added at S$_i$(t)
err$_q$(t) : error signal from downconversion, added at S$_q$(t)

Considering that at the err$_i$(t) & err$_q$(t) low frequency components are present and after analog to digital conversion at 16 and 17, the following equations are extracted by differentiating the signal power ($S_{ie}^2+S_{qe}^2$) :

$$F(n \cdot T_s) = err_i \times G(n \cdot T_s) + err_q \times H(n \cdot T_s) \tag{5}$$

$$F(n \cdot T_s + T_s) = err_i \times G(n \cdot T_s + T_s) + err_q \times H(n \cdot T_s + T_s) \tag{6}$$

where:

$T_s$: conversion rate of the 16 and 17 ADC converters
err$_i$ & err$_q$: are to be calculated
G(n•T$_s$), H(n•T$_s$), F(n•T$_s$): can be calculated using S$_{ie}$(t) and S$_{qe}$(t)

Using the equations (5) & (6) the err$_i$ and err$_q$ can be calculated. All the calculations are performed at the digital part, after the 16 and 17 ADC converters. The error factor is independent of the T$_s$ value.
By using the values of the err$_i$ and err$_q$ as inputs to digital filters and converting the digital signals to analog ones (23 and 24 DAC converters), the correction analog signals are generated. The closed loop transfer function of the filters should be of Low Pass type. The transfer function of the open loop filter is the following:

$$Ho(z) = \frac{1 + z^{-1} + z^{-2} + ... + z^{-n}}{n - z^{-1} - z^{-2} - z^{-3} - ... - z^{-(n+1)}} \tag{7}$$

The closed loop transfer is the following:

$$Hc(z) = \frac{1 + z^{-1} + z^{-2} + ... + z^{-n}}{n} \tag{8}$$

Both transfer functions are very easy to implement using digital circuitry.
When no signal is present at the antenna the above algorithm is bypassed. The input samples through the 16 and 17 ADC converters should be of constant value and they represent the static DC offset error, caused mainly by the mixers' 4 and 5 internal asymmetries and the LO 3 feedthrough. The input samples are used as input through the digital filters 20, 21 and 22. The calculated values at the filters' outputs are used as initial values when signal is present at the antenna, so as to minimize the settling time of the algorithm.
Another important factor for the settling time is the conversion rate of both ADC (16 and 17) and DAC (23, 24, 25) converters and the characteristics of the digital filters (20, 21, 22). A trade off between settling time and high speed converters (increased power consumption), gate count at the filters is necessary for the optimization according to the specifications.
The baseband analog signals, after DC offset Correction at subtractors 6 and 7 are adjusted to the desired level through the Automatic Gain Control, AGC 8 and 9, block and multipliers 12 and 13 with standard gain value, gct 14 and 15, as it is shown at the block diagram of the receiver at the figure 1. The Automatic Gain control Algorithm, AGCA 19, which calculates the peak value of the S$_{ie}$(t) and S$_{qe}$(t) input signals, uses the following formula:

$$S_{ie}^2(t) + S_{qe}^2(t) \tag{9}$$

The calculation of both the DC offset and the peak value, for each input, is updated at every digital sample at the digital part. In that way the correction signals track any low frequency wander at both the DC offset and the peak value. This is very important at the case of high gain present at the loop. An uncorrected wander at the error signals results to overflow the following stages.

The DC offset is compensated before the ADC 16 and 17 converters. In that way both the input baseband signals at the ADCs' inputs are amplified (through the AGC stage) at the maximum allowed level. So the number of bits of the ADCs can be minimized. In that way power consumption and conversion time can be decreased. In case any of the ADC converters overflow during the slot (change at the DC offset values) the algorithm initializes the correction signals and adjusts to the new values. This is quite possible to happen during one slot time window due to the presence of external interference.

In figures 2 and 3 the simulated results of the performance of the OCA 18 are included. The settling time of the algorithm depends on the conversion rate of the ADC and DAC converters. In the simulation results serial interface converters are used. The analog correction signals presented at the figure 3 are the outputs of the 23 and 24 DAC converters.

**Claims**

1. This invention relates to an offset correction algorithm, OCA, and Automatic Gain Control Algorithm, AGCA, in a zero-IF wireless receiver. The circuit corrects DC and low frequency error functions which are added to said baseband modulation components (I & Q) and are produced from said components asymmetries (static DC Offset) and from said direct to baseband downconversion procedure. At the proposed circuit said calculation of said peak value of said input signals is included. This is necessary in order to control said gain of said AGC block. All said calculations are performed digitally. By using DAC converters at said baseband part of said receiver, all said correction analog signals are generated.

2. Correction circuit, using OCA, according to claim 1 calculates all said correction values with a frequency that can be equal to said conversion rate of said ADC converters. In that way any low frequency components that are present both at said Offset and at said peak value of said input signals can be tracked.

3. Correction circuit according to claim 2 can trace any change at said peak value or at said offset within said slot or at the beginning of a new slot. In the case that said digital outputs of said ADC converters saturate to minimum or maximum level all said correction signals are initialized and start to converge to new values. In the case that said digital outputs of said ADC converters are between minimum and maximum level, said correction signals adjust to said new values.

4. Correction circuit, using OCA, according to claim 1 calculates initial correction values for said offset in order to minimize settling time (static DC Offset).

5. Correction circuit, using OCA, according to claim 1 is able of calculating said correction signals even if said DC errors at said I and Q components have a different value.

EP 1 172 928 A2

Figure 1

Figure 2

Figure 3

EP 1 172 928 A2